(19) Europäisches Patentamt
European Patent Office
Office européen des brevets

(11) Publication number: **0 385 031 B1**

(12) **EUROPEAN PATENT SPECIFICATION**

(45) Date of publication of patent specification: **22.06.94**

(51) Int. Cl.5: **H01L 29/60**, H01L 29/812, H01L 21/28, H01L 29/08, H01L 29/10

(21) Application number: **89312416.4**

(22) Date of filing: **29.11.89**

(54) **Semiconductor device with a recessed gate, and a production method thereof.**

(30) Priority: **03.03.89 JP 52649/89**

(43) Date of publication of application:
**05.09.90 Bulletin 90/36**

(45) Publication of the grant of the patent:
**22.06.94 Bulletin 94/25**

(84) Designated Contracting States:
**DE FR GB**

(56) References cited:
**EP-A- 0 252 888**

**IEEE TRANSACTIONS ON ELECTRON DE-VICES, vol. ED-34, no. 6, June 1987, pages 1259-1263, IEEE, New York, US; G.C. TAYLOR et al.: "High-efficiency 35-GHz GaAs MES-FET's"**

**PATENT ABSTRACTS OF JAPAN, vol. 12, no. 498 (E-698)[3345], 26th December 1988; & JP-A-63 208 275**

(73) Proprietor: **MITSUBISHI DENKI KABUSHIKI KAISHA**
**2-3, Marunouchi 2-chome**
**Chiyoda-ku**
**Tokyo(JP)**

(72) Inventor: **Hayase, Iwao c/o Mitsubishi Denki K. K.**
**Kitaitami Seisakusho**
**No. 1, Mizuhara 4-chome**
**Itami-shi Hyogo-ken(JP)**
Inventor: **Sonoda, Takuji c/o Mitsubishi Denki K. K.**
**Kitaitami Seisakusho**
**No. 1, Mizuhara 4-chome**
**Itami-shi Hyogo-ken(JP)**

(74) Representative: **Beresford, Keith Denis Lewis et al**
**BERESFORD & Co.**
**2-5 Warwick Court**
**High Holborn**
**London WC1R 5DJ (GB)**

EP 0 385 031 B1

PATENT ABSTRACTS OF JAPAN, vol. 12, no. 393 (E-670)[3240], 19th October 1988; & JP-A-63 133 680

PATENT ABSTRACTS OF JAPAN, vol. 9, no. 53 (E-301)[1776], 7th March 1985; & JP-A-59 193 069

**Description**

The present invention relates to a production method for a semiconductor device having a recessed gate electrode, particularly a field effect transisotr having a two stage recess structure with a T-shaped gate electrode therein.

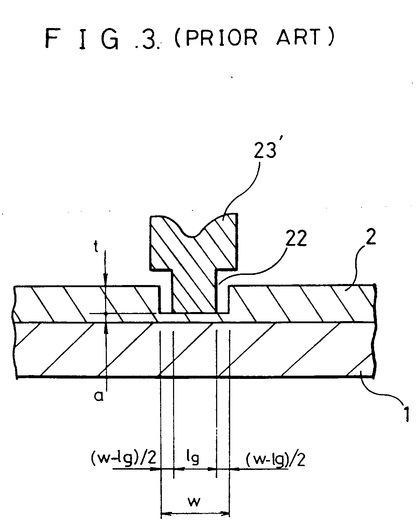

Figure 3 shows a recess structure and a T-shaped gate electrode structure of a prior art field effect transistor. In figure 3, reference numeral 1 designates a GaAs substrate. An active layer 2 is produced on the GaAs substrate 1. A recess portion 22 is produced at the active layer 2, and a T-shaped gate electrode 23' is produced on the recess portion 22. Reference character (w) represents width of recess, (t) represents depth of recess, (a) represents thickness of the active layer 2 below the gate electrode 23', and (lg) represents length of the gate electrode 23'.

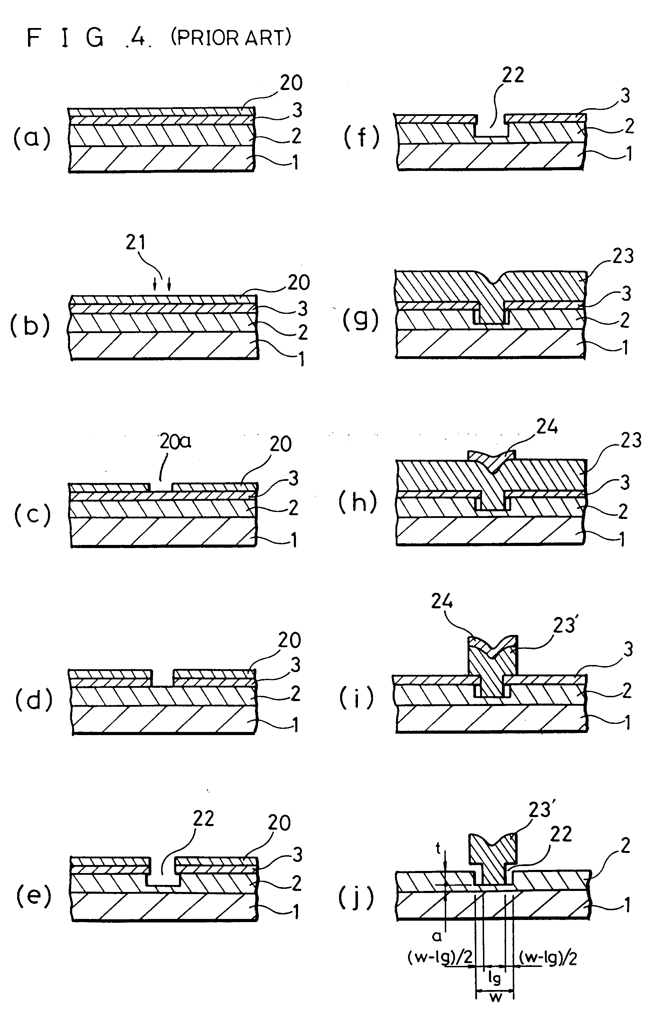

A production method of a prior art field effect transistor will be described with reference to figure 4(a) to (j).

First of all, as shown in figure 4(a), a nitride film 3 is deposited on the active layer 2 produced on the substrate 1 by such as plasma CVD (Chemical Vapor Deposition), and an electron beam resist such as PMMA (polymethylmethacrylate) resist 20 is plated thereon by such as spin coating.

Next, as shown in figure 4(b), an electron beam 21 is irradiated to the PMMA resist 20, and a development is conducted to produce an aperture portion 20a as shown in figure 4(c).

Next, as shown in figure 4(d), the nitride film 3 is etched by such as RIE (reactive ion etching) using the resist 20 as a mask, and thereafter as shown in figure 4(e), the active layer 2 is recess etched by chemical etching thereby to produce a recess aperture portion 22.

Thereafter, as shown in figure 4(f), the PMMA resist 20 is removed, and as shown in figure 4(g), the gate metal 23 is produced on the entire surface by such as vapor deposition.

Next, as shown in figure 4(h), a pattern of a head portion of a T-shaped gate is produced by utilizing the negative type resist 24, and as shown in figure 4(i), the gate metal 23 is etched by such as ion milling thereby to produce a gate electrode 23'.

Finally, as shown in figure 4(j), the negative type resist 24 and the nitride film 3 are removed thereby to produce a recess type T-shaped gate field effect transistor having a T-shaped gate electrode 23' at the recess aperture portion 22.

The FET of this structure is produced of a recess structure in which a portion of the active layer 2 where a gate electrode is to be produced is etched up to an active layer thickness (a) corresponding to the carrier concentration N by an etching so as to enable to obtain a predetermined current value. By the recess width (w) and the recess depth (t) of the recess structure, the RF performance and the gate reverse direction breakdown voltage are largely affected. Further, there is a tendency that as the gate reverse direction breakdown voltage is increased, the RF performance is deteriorated. They are thought to be caused by that the broadening of the depletion layer which determines the gate reverse direction breakdown voltage and the parasitic resistance and parasitic capacitance which give large influences on the RF performance vary largely dependent on the recess structure and in view of that optimization of the recess width (w) and recess depth (t) are attempted. However, in the method of controlling the recess width (w) and recess depth (t), there are many restrictions in the enhancement of breakdown voltage and that of performances. In the prior art one stage recess structure, concentration of electric fields onto the recess edges may arise, thereby unabling to disperse the concentration of electric field between gate and drain. On the other hand, as a measure for improving these parasitic resistances and parasitic capacitances, a T-shaped gate structure is adopted. However, the adoption of such T-shaped gate structure even cannot exhibit sufficient effects in reductions of parasitic resistances and parasitic capacitances in the case of the one stage recess structure.

The use of, and advantages of, a T-shaped gate structure are known. For example, "High Efficiency 35-GHz Gu As MESFET", IEEE ED-34, No. 6, June '87, pages 1259-1263.

As discussed above, in the prior art FET of such construction, there are many restrictions in the enhancement of breakdown voltage and that of performances, and it was difficult to reduce the parasitic resistances between gate and source by only the optimization of the recess width (w) and recess depth (t) of the one stage recess structure and the adoption of T-shaped gate structure. Further, in such recess structure, the concentration of electric fields between gate and drain would unfavorably be concentrated at a portion of recess edge.

A device which has improved such prior art one stage recess structure will be described below.

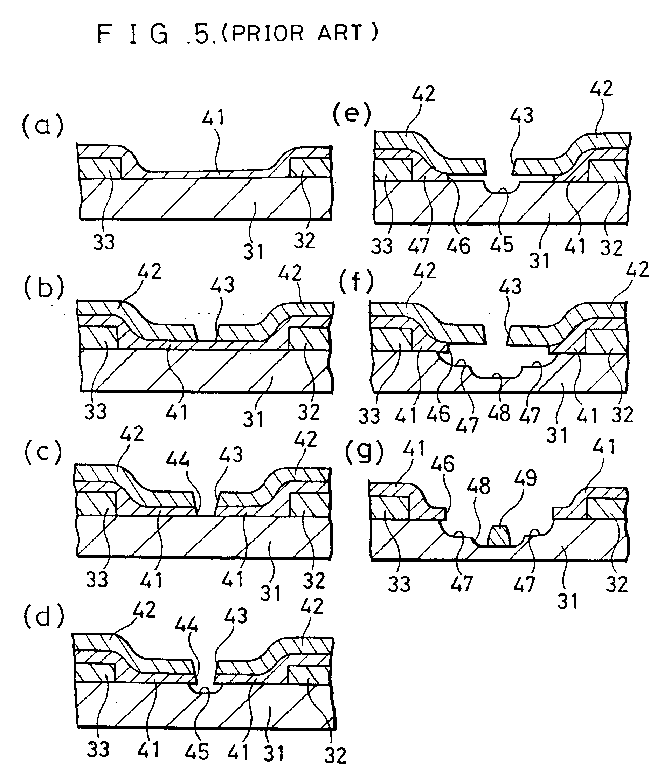

Figures 5(a) to (g) show major production process steps of a production method of a semiconductor device having a two stage recess structure disclosed in Japanese Patent Laid-Open Publication No. 61-89681. In figure 5, reference numeral 31 designates a semiconductor substrate. A source electrode 32 and a drain electrode 33 are provided on the semiconductor substrate 31. A spacer film 41 is produced on the entire surface of substrate. A photoresist film 42 is produced on the spacer film 41. A window 43 is apertured at the photoresist 42. A first aperture portion 44 is apertured at the spacer film 41 by etching utilizing the window 43 of the photoresist film 42. A concave portion 45 is produced on the substrate 31 by an etching through the window 43 and the first aperture portion 44. A second aperture portion 46 is produced at the spacer film 41 by conducting again etching of the spacer film 41 through the window 43 of the photoresist 42. A first stage recess 47 is produced on the substrate 31 by conducting an etching through the window 43 and the second aperture portion 46. Then, a second stage recess 48 is produced at the center of the first stage recess 47 on the substrate 31. A gate electrode 49 is produced on the second stage recess 48.

The production process will be described.

First of all, as shown in figure 5(a), a source electrode 32 and a drain electrode 33 are produced on the main surface of semiconductor substrate 31 with providing a predetermined distance therebetween, and thereafter over the main surface of the semiconductor substrate 31 and the surfaces of the source and drain electrode 32 and 33, a spacer film 41 comprising such as silicon nitride film or silicon oxide film is produced. This spacer film 41 can be etched by a second etching solution which is of a different kind from the first etching solution by which the semiconductor substrate 31 can be etched.

Next, as shown in figure 5(b), a photoresist film 42 is produced on the surface of the spacer film 41, and a window having a pattern corresponding to the pattern of the gate electrode is produced at a portion of the photoresist film 42 corresponding to a portion on the semiconductor substrate 31 where a gate electrode is to be produced between the source electrode 31 and the drain electrode 33.

Next, as shown in figure 5(c), using the photoresist 42 having a window 43 as a mask, a first aperture portion 44 having a pattern corresponding to the pattern of the window 43 is produced in the spacer film 41 by an etching utilizing the second etching solution.

Next, as shown in figure 5(d), a concave portion 45 for producing a second recess is produced at the main surface portion of the semiconductor substrate 31 by an etching utilizing the first etching solution with using the spacer film 41 having a first aperture portion 44 as a mask.

Next, as shown in figure 5(e), a second aperture portion 46 having a pattern corresponding to the pattern of first stage recess is produced by expanding the pattern of the first aperture portion 44 at the spacer film 41 by an etching utilizing the second etching solution with using the photoresist film 42 having the window 43 as a mask.

Next, as shown in figure 5(f), a first stage recess 47 having a pattern corresponding to a pattern of the second aperture portion 46 is produced at a portion of the main surface of the semiconductor substrate 31 by an etching utilizing the first etching solution using the spacer film 41 having the second aperture portion 46 as a mask, and at the same time a second stage recess 48 corresponding to a pattern of concave portion 45 is produced at a portion of the bottom surface of the first stage recess 47.

Finally, as shown in figure 5(g), a deposition film of gate electrode production metal is produced on the surface of the photoresist film 42 having the window 43 and the bottom surface of the second stage recess 48, and the photoresist film 42 is removed together with the gate metal deposition film on the surface thereof by a lift-off method, thereby to produce a gate electrode 49 on the bottom surface of the second stage recess 48, thereby completing an element of a two stage recess structure.

In the semiconductor device according to the above-described production method, a gate electrode production portion can be produced in a two stage recess structure, and concentration of electric field onto the recess edges can be relaxed, thereby enhancing the breakdown voltage of the device.

In the above prior art production method of an FET, however, since the gate electrode is produced at the central portion of recess, the inter-gate source distance is made equal to the inter-gate drain distance, and the enhancement of the drain breakdown voltage leading to the enhancement in the RF performances and the reduction in the inter-gate source capacitance and the source resistance cannot be accomplished at the same time. As has been demonstrated in the prior art (for example see Patent Abstracts of Japan, Vol 12, No 498 (E-698) (3345) 26/12/88 and European Patent Application EP-A-252888) it is not necessary that the gate be central to the source and the drain. In the case of power MESFETS it is desirable that the gate is offset towards the source.

Further, according to such a production method, the produced gate elecrode has a trapezoidal configuration and it is quite difficult to produce a gate of below 0.5 micron length. Further, it is necessary to use apparatus such as EB (Electron Beam) or FIB (Focused Ion Beam) in order to miniaturize the gate length, thereby resulting in a problem in the mass production. Further, in such gate electrode structure, the gate cross-sectional area is reduced accompanying with the miniaturization of the gate length, which unfavorably results in difficulty in the reduction of gate resistance. Further, according to the above-described production method, the width of the first stage recess 47 is determined by the degree of side etching of the spacer film 41 in the process of figure 5(e), and the conclusion point of this side etching is difficult to be detected because the conclusion point is located below the photoresist 42, which results in difficulty in conducting etching at a high controllability and at a high reproducibility. Thus, there are many restrictions in the enhancement of the breakdown voltage and the performance in the prior art semiconductor device and production method thereof, and therefore it was difficult to enhance the gate reverse direction breakdown voltage and to reduce the gate resistance and inter-gate source parasitic resistance.

According to the present invention there is provided a production method of a semiconductor device as set out in Claim 1. Optional features are set out in the remaining claims.

Figure 1 is a cross-sectional view showing a semiconductor device produced according to the present invention;

Figures 2(a) to (g) are cross-sectional views showing a semiconductor device in the major production process steps of a production method of a semiconductor device according to the present invention:

Figure 3 is a cross-sectional view showing a prior art semiconductor device;

Figures 4(a) to (j) are cross-sectional views showing a semiconductor device in the major production process steps of the production method of the device of figure 3; and

Figures 5(a) to (g) are cross-sectional views showing a semiconductor device in the major production process steps according to another prior art method.

An embodiment of the present invention will be described in detail with reference to the drawings.

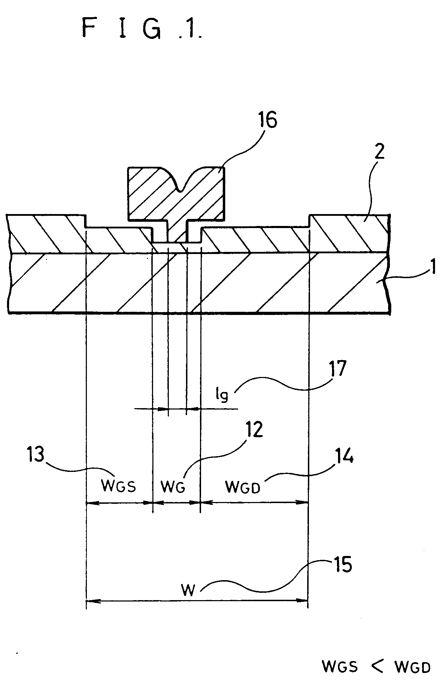

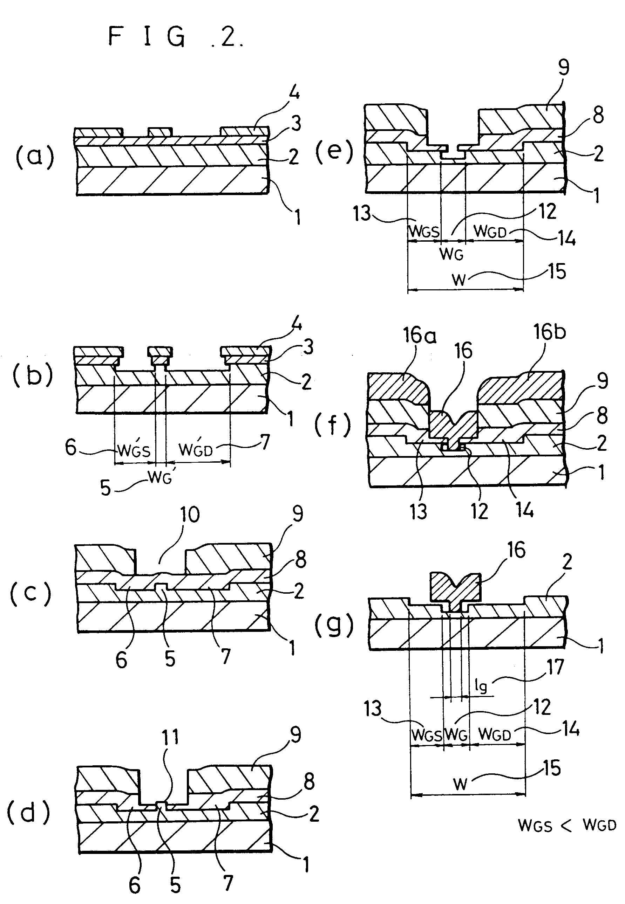

Figure 1 shows a field effect transistor as an embodiment of the present invention, and figures 2(a) to (g) are cross-sectional views in the respective major production process steps in the production process of the semiconductor device of figure 1.

In these figures, the same reference numerals designate the same or corresponding elements as those shown in figures 3 and 4. Reference numeral 4 designates positive type resist which is plated on the nitride film 3. Reference numeral 5 designates a dummy gate portion having width $W_G'$ which is obtained by conducting chemical etching to the upper stage portion of the active layer 2. Reference numeral 6 designates an upper stage gate/source recess aperture portion which is obtained by conducting chemical etching to the upper stage portion of the active layer 2 having width $W_{GS}'$. Reference numeral 7 designates an upper stage gate/drain recess aperture portion which is obtained by conducting chemical etching to the upper stage portion of the active layer 2 having width $W_{GD}'$. Reference numeral 8 designates a nitride film deposited on the entire surface of substrate so as to cover the aperture portions 6 and 7. Reference numeral 9 designates a resist for producing a T-shaped gate head portion. Reference numeral 10 designates an aperture portion corresponding to the T-shaped gate head portion of the resist 9. Reference numeral 11 designates a top portion of the dummy gate 5. Reference numeral 12 designates a lower stage recess portion which is obtained by conducting a chemical etching to the lower stage portion of the active layer 2 having width $W_G$. Reference numeral 13 designates an upper stage gate/source recess aperture portion which is produced after producing a lower stage recess portion 12 having the width $W_{GS}$. Reference numeral 14 designates an upper stage gate/drain recess aperture portion having width $W_{GD}$ which is similarly produced. Reference numeral 15 designates recess width (W) of the upper stage recess. Reference numeral 16 designates a gate electrode, reference numerals 16a and 16b designate gate electrode metal, and reference numeral 17 designates gate length lg of the gate electrode 16.

The production process of the FET of figure 1 will be described.

First of all, as shown in figure 2(a), an active layer 2 is produced to a thickness of about 1 micron by conducting epitaxial growth on the GaAs semiconductor substrate 1 or conducting ion implantation into the substrate 1. Thereafter, a film 3 such as SiO, SiN, or SiON is deposited on the active layer 2 to a thickness of 1000 to 2000 Angstroms by such as plasma CVD, and positive type resist 4 is deposited thereon and a patterning of the positive type resist 4 for producing an upper stage recess portion is conducted. Then it is produced that the resist pattern produced have a pattern size of 0.4 to 0.5 microns and that the width of inter-source gate recess aperture portion be narrower than the width of the inter-drain gate recess aperture portion. More preferably, the ration of width of source/gate recess to that of gate/drain recess is 1/2.

Next, as shown in figure 2(b), the nitride film 3 is removed by such as with using the pattern 4, and the active layer 2 is recess etched by chemical etching, thereby producing a dummy gate 5 of width $W_G'$ ($\approx$ 0.2 micron), an upper stage gate/source recess aperture portion 6 of width $W_{GS}'$, and an upper stage gate/drain recess aperture portion 7 of width $W_{GD}'$.

Next, as shown in figure 2(c), the positive type resist 4 and the nitride film 3 are removed, and a nitride film 8 is produced on the active layer 2 by such as plasma CVD, and further a resist is produced on the nitride film 8, and a resist pattern 9 having a T-shaped gate head portion aperture portion 10 for producing a head portion of a T-shaped gate electrode is produced. Herein, the width of the T-shaped gate top portion aperture portion is pattern designed to be shorter than the length W (= $W_{GD}' + W_{GS}' + W_{G}'$) of the above-described upper stage recess aperture portion.

Next, as shown in figure 2(d), the nitride film 8 is etched by such as RIE to expose the top of the dummy gate 5 (the dummy gate top exposure portion is 11), and subsequently, as shown in figure 2(e), the active layer 2 is chemical etched by such as wet etching using tartaric acid thereby to produce a lower stage recess 12 of width $W_G$, and thus an upper stage gate/source recess aperture portion 13 having width $W_{GS}$ and an upper stage gate/drain recess aperture portion 14 having width $W_{GD}$ are obtained. By the above described process, an upper stage recess 15 of width W (= $W_{GD}$ + $W_{GS}$ + $W_G$) and a lower recess 12 of width $W_G$ are produced in positional relationship of $W_{GS}$ < $W_{GD}$, and a two stage recess structure of off-set type in which the gate/drain interval is narrower than the gate/source interval is produced.

Next, as shown in figure 1(f), metal of such as Ti/Mo/Au or Ti/Al as a Schottky metal is deposited on the entire surface of substrate to a thickness of about 1 micron by such as electron beam deposition, and next the gate metals 16a and 16b and the resist 9 are removed by such as lift-off method, and subsequently, the nitride film 8 is removed by such as wet etching, thereby to obtain an off-set type two stage recess T-shaped gate structure FET having a gate length lg 17 of figure 1(g).

By the production method of the present invention as described above, the nitride film 3 and the active layer 2 are successively side-etched utilizing the dummy gate production resist 4 having a width of 0.4 to 0.5 microns as a mask to produce a dummy gate 5 of width $W_G'$ as shown in figures 2-(a) to (b), and further the gate length lg of the T-shaped gate 16 which will be produced later is determined by the width $W_G'$ of this dummy gate 5. Therefore, by controlling the side etching of the active layer 2 in the process of figures 2(a) to (b), the gate length lg can be made fine patterned up to below 0.5 microns, for example 0.2 micron, and a fine pattern gate electrode 16 can be produced at high precision. Further, accompanying with the fine patterning of the gate length, the gate parasitic capacitance can be reduced. Further, since the configuration of the gate electrode 16 of T-shaped, the cross-sectional area of the gate electrode can be increased and the reduction in the gate resistance can be accomplished. Further, since the recess portion is produced in a two stage, the concentration of electric fields can be prevented, and the leak current between the active layer and the buffer layer at below the active layer can be reduced, and the electric field between gate and drain can be dispersed. Further, since the narrow width recess stage is arranged at a position closer to the source electrode, the increase in the inter-source gate resistance can be suppressed. From the above-discussion, the RF performance can be enhanced and the enhancements in the device performances and the breakdown voltage can be accomplished.

As is evident from the foregoing description, according to the present invention, a two stage recess T-shaped gate structure is provided with an upper stage recess portion of broad width produced on a semiconductor substrate between a source electrode and a drain electrode, a narrow width lower stage recess portion arranged on this upper stage resist portion at a position closer to the source electrode than the drain electrode, and a T-shaped gate electrode having a broad width head portion which is produced on the lower stage recess portion. Therefore, the concentrations of electric fields can be dispersed due to the fact that the recess portion is produced in a two stage, and electric field between gate and drain can be dispersed, and the leak current between the active layer and the buffer layer can be reduced. Further, since the narrow width recess stage is arranged at a position closer to the source electrode, the increase in the inter-source gate parasitic resistance can be suppressed. Further, by the adoption of the T-shaped gate, the reduction in the parasitic capacitance due to the fine pattern gate length lg and the reduction in the parasitic resistance due to the increase in the gate cross-sectional area can be accomplished, thereby resulting in enhancement in the device performances and enhancement in the breakdown voltage.

According to another aspect of the present invention, a broad width upper stage recess portion is produced on a semiconductor substrate with remaining a dummy gate portion, a pattern for producing a head portion of T-shaped gate electrode is produced, top exposure of the dummy gate is conducted by utilizing this pattern, and a narrow width lower stage recess portion is produced at a position closer to the source electrode, thereby to obtain a two stage recess structure, and thereafter a T-shaped gate electrode is produced at a lower stage recess portion. Thus, an FET having a T-shaped gate electrode, having an off-set type two stage recess structure can be sufficiently produced by the conventional apparatuses, and a high breakdown voltage and high efficiency FET can be produced at low cost and at high precision. Further, a broad width recess stage and a narrow width recess stage can be easily produced at high precision and a gate electrode production pattern can be produced at the production of the recess stage at high precision. Thus, the production of T-shaped gate electrode can be easily accomplished at high precision.

## Claims

1. A production method for a semiconductor device having a T-shaped gate electrode (16) having a broad width head portion at a two stage recess portion, comprising:

a first step of producing a broad width upper stage recess portion (6,7) on an active layer (2) of a semiconductor substrate (1) leaving a dummy gate portion (5), said upper stage recess having a gate/source recess portion (6), and a gate/drain recess portion (7);

a second process of producing a pattern for producing said head portion (9) of said T-shaped gate electrode (16);

a third process of exposing said dummy gate portion (5) utilizing said pattern (9), and thereafter producing a narrow width lower stage recess portion (12) at a position closer to said source electrode, thereby to produce a two stage recess structure; and

a fourth process of producing a T-shaped gate electrode (16) at said lower stage recess portion (12).

2. A production method for a semiconductor device as defined in claim 1, wherein;

said first process comprises producing a first nitride film (3) on an active layer (2) on a semiconductor substrate (1), and etching said first nitride film (3) and said active layer (2) using a first resist pattern (4) as a mask, thereby producing said gate/source recess portion (6) of width $W_{GS}'$, said gate/drain recess portion (7) of width $W_{GD}'$, and said dummy gate portion (5) of width $W_G'$ in a relation of $W_{GS}' < W_{GD}'$ (herein, $W_{GS}' + W_G' + W_{GD}' = W$, W is width of the upper stage recess);

said second process comprises producing a second nitride film (8) on the entire surface of said substrate so as to bury said dummy gate portion (5), said gate/source recess portion (6), and said gate/drain recess portion (7) after removing said first resist pattern (4) and first nitride film (3), and producing a second resist pattern (9) having an aperture portion for a T-shaped gate head portion (10) for producing a head portion of said T-shaped gate electrode (16) on said second nitride film (8);

said third process comprises conducting top exposure of said dummy gate portion (5) by etching said second nitride film (8) using said second resist pattern (9) as a mask, and producing a lower stage recess portion (12) of width $W_G$ by etching said active layer (2) using said second resist (9) and said second nitride film (8) as a mask, and producing said upper stage gate/source recess portion (13) of width $W_{GS}$ and said upper stage gate/drain recess portion (14) of width $W_{GD}$ (herein, $W_G + W_{GD} + W_{GS} = W$); and

said fourth process comprises vapor depositing gate electrode metal (16, 16a, 16b) on the entire surface of substrate and removing said second resist (9) and gate electrode metal (16a,16b) produced thereon by a lift-off method, and thereafter removing said second nitride film (8) thereby to produce a T-shaped gate electrode (16) having a broad width head portion on said lower stage recess portion (12).

3. A production method for a semiconductor device as defined in claim 2, wherein the ratio of said $W_{GS}'$ to $W_{GD}'$ and the ratio of said $W_{GS}$ to $W_{GD}$ are in a relation of 1 : 2.

## Patentansprüche

1. Verfahren zur Herstellung einer Halbleiteranordnung mit einer an einem zweistufigen Nutabschnitt ausgebildeten T-förmigen Gateelektrode (16) mit einem breiten Kopfabschnitt, das die folgenden Schritte aufweist:

ein erster Schritt zum Ausbilden eines breiten Nutabschnitts einer oberen Stufe (6, 7) auf einer aktiven Schicht (2) eines Halbleitersubstrats (1) unter Zurücklassen eines Attrappengateabschnitts (5), wobei die Nut der oberen Stufe einen Gate/Source Nutabschnitt (6) und einen Gate/Drain Nutabschnitt (7) aufweist;

ein zweiter Verfahrensschritt zum Ausbilden eines Musters zum Ausbilden des Kopfabschnitts (9) der T-förmigen Gateelektrode (16);

ein dritter Verfahrensschritt zum Belichten des Attrappengateabschnitts (5) unter Verwendung des Musters (9) und zum darauffolgenden Ausbilden eines schmalen Nutabschnitts (12) einer unteren Stufe in einer näher an der Sourceelektrode angeordneten Position, um somit eine zweistufige Nutstruktur auszubilden; und

ein vierter Verfahrensschritt zum Ausbilden einer T-förmigen Gateelektrode (16) an dem Nutabschnitt (12) der unteren Stufe.

2. Verfahren zur Herstellung einer Halbleiteranordnung nach Anspruch 1, wobei

der erste Verfahrensschritt die Schritte umfaßt:

Ausbilden eines ersten Nitridfilms (3) auf einer aktiven Schicht (2) auf einem Halbleitersubstrat (1) und Ätzen des ersten Nitridfilms (3) und der aktiven Schicht (2) unter Verwendung eines ersten Lackmusters (4) als Maske, wodurch der Gate/Source Nutabschnitt (6) der Weite $W_{GS}'$, der Gate/Drain Nutabschnitt (7) der Weite $W_{GD}'$ und der Attrappengateabschnitt (5) der Weite $W_G'$ in einer Beziehung $W_{GS}' < W_{GD}'$ ausgebildet werden (hierbei gilt: $W_{GS}' + W_G' + W_{GD}' = W$, wobei W die Weite der Nut der oberen Stufe ist);

der zweite Verfahrensschritt die Schritte umfaßt:

Ausbilden eines zweiten Nitridfilms (8) auf der gesamten Oberfläche des Substrats derart, daß der gesamte Attrappengateabschnitt (5), der Gate/Source Nutabschnitt (6) und der Gate/Drain Nutabschnitt (7) nach dem Entfernen des ersten Lackmusters (4) und Nitridfilms (3) vergraben sind, und Ausbilden eines zweiten Lackmusters (9) mit einer Fensteröffnung (10) für einen Kopfabschnitt eines T-förmigen Gates zum Ausbilden eines Kopfabschnitts der T-förmigen Gateelektrode (16) auf dem zweiten Nitridfilm (8);

der dritte Verfahrensschritt die Schritte umfaßt:

Ausführen der Oberflächenbelichtung des Attrappengateabschnitts (5) durch Ätzen des zweiten Nitridfilms (8) unter Verwendung des zweiten Lackmusters (9) als Maske; Ausbilden eines Nutabschnitts (12) einer unteren Stufe der Weite $W_G$ durch Ätzen der aktiven Schicht (2) unter Verwendung des zweiten Lacks (9) und des zweiten Nitridfilms (8) als Maske und Ausbilden des Gate/Source Nutabschnitts (13) der oberen Stufe der Weite $W_{GS}$ und des Gate/Drain Nutabschnitts der oberen Stufe der Weite $W_{GD}$ (hierbei gilt $W_G + W_{GD} + W_{GS} = W$); und

der vierte Verfahrensschritt die Schritte umfaßt:

Aufdampfen eines Gateelektrodenmetalls (16, 16a, 16b) auf der gesamten Substratoberfläche und Entfernen des zweiten Lacks (9) und des darauf abgeschiedenen Gateelektrodenmetalls (16a, 16b) mittels eines Abhebe-Verfahrens und darauffolgend Entfernen des zweiten Nitridfilms (8), um somit eine T-förmige Gateelektrode (16) mit einem breiten Kopfabschnitt auf dem Nutabschnitt (12) der unteren Stufe auszubilden.

3. Verfahren zur Herstellung einer Halbleiteranordnung nach Anspruch 2, bei dem das Verhältnis von $W_{GS}'$ zu $W_{GD}'$ und das Verhältnis von $W_{GS}$ zu $W_{GD}$ 1:2 beträgt.

**Revendications**

1. Un procédé de fabrication pour un dispositif à semiconducteurs ayant une électrode de grille en forme de T (16) qui présente une partie de tête de grande largeur dans une partie de cavité à deux étages, comprenant :

une première étape qui consiste à produire une partie de cavité d'étage supérieur de grande largeur (6, 7) sur une couche active (2) d'un substrat semiconducteur (1), en laissant une partie de grille fictive (5), cette cavité d'étage supérieur ayant une partie de cavité de grille/source (6) et une partie de cavité de grille/drain (7) ;

une seconde étape qui consiste à former un motif (9) pour produire la partie de tête de l'électrode de grille en forme de T (16) ;

une troisième étape qui consiste à mettre à nu la partie de grille fictive (5) en utilisant le motif précité (9), et à produire ensuite une partie de cavité d'étage inférieur de faible largeur (12), dans une position plus proche de l'électrode de source, pour produire ainsi une structure de cavité à deux étages ; et

une quatrième étape qui consiste à produire une électrode de grille en forme de T (16) dans la partie de cavité d'étage inférieur (12).

2. Un procédé de fabrication pour un dispositif à semiconducteurs selon la revendication 1, dans lequel :

la première étape comprend la formation d'une première pellicule de nitrure (3) sur une couche active (2) sur un substrat semiconducteur (1), et la gravure de la première pellicule de nitrure (3) et de la couche active (2) en utilisant à titre de masque un premier motif de matière de réserve (4), pour former ainsi la partie de cavité de grille/source (6) de largeur $W_{GS}'$, la partie de cavité de grille/drain (7) de largeur $W_{GD}'$, et la partie de grille fictive (5) de largeur $W_G'$ selon une relation $W_{GS}' < W_{GD}'$ (on a ici, $W_{GS}' + W_G' + W_{GD}' = W$, W étant la largeur de la cavité d'étage supérieur) ;

la seconde étape comprend la formation d'une seconde pellicule de nitrure (8) sur la totalité de la surface du substrat, de façon à enterrer la partie de grille fictive (5), la partie de cavité de grille/source (6) et la partie de cavité de grille/drain (7), après avoir enlevé le premier motif de matière de réserve (4) et la première pellicule de nitrure (3), et la formation d'un second motif de matière de réserve (9) ayant une partie d'ouverture pour une partie de tête de grille en forme de T (10), pour produire une partie de tête de l'électrode de grille en forme de T (16) sur la seconde pellicule de nitrure (8) ;

la troisième étape comprend la mise à nu de la surface supérieure de la partie de grille fictive (5) par gravure de la seconde pellicule de nitrure (8), en utilisant à titre de masque le second motif de matière de réserve (9), et la formation d'une partie de cavité d'étage inférieur (12) de largeur $W_G$, par gravure de la couche active (2) en utilisant à titre de masque le second motif de matière de réserve (9) et la seconde pellicule de nitrure (8) et la formation de la partie de cavité de grille/source d'étage supérieur (13) de largeur $W_{GS}$ et de la partie de cavite de grille/drain d'étage supérieur (14) de largeur de $W_{GD}$ (on a ici $W_G + W_{GD} + W_{GS} = W$) ; et

la quatrième étape comprend le dépôt en phase vapeur d'un métal d'électrode de grille (16, 16a, 16b) sur la totalité de la surface du substrat et l' enlèvement de la seconde matière de réserve (9) et du métal d'électrode de grille (16a, 16b) qui est formé sur elle, par un procédé de décollement, et ensuite l'enlèvement de la seconde pellicule de nitrure (8), pour former ainsi une électrode de grille en forme de T (16) ayant une partie de tête de grande largeur sur la partie de cavité d'étage inférieur (12).

3. Un procédé de fabrication pour un dispositif à semiconducteurs selon la revendication 2, dans lequel le rapport entre $W_{GS'}$ et $W_{GD'}$ et le rapport entre $W_{GS}$ et $W_{GD}$ sont dans une relation de 1 : 2.

# F I G .1.

WGS < WGD

# F I G .2.

$W_{GS} < W_{GD}$

F I G .3. (PRIOR ART)

F I G .4. (PRIOR ART)

(a) 20 3 2 1

(b) 21 20 3 2 1

(c) 20a 20 3 2 1

(d) 20 3 2 1

(e) 22 20 3 2 1

(f) 22 3 2 1

(g) 23 3 2 1

(h) 24 23 3 2 1

(i) 24 23' 3 2 1

(j) 24 23' 22 2 1
t
a
(w-lg)/2   (w-lg)/2
lg
w

F I G .5.(PRIOR ART)

(a)

(e)

(b)

(f)

(c)

(g)

(d)